# EUROPEAN PATENT SPECIFICATION

(11) **EP 1 891 529 B1**
(45) Date of publication and mention of the grant of the patent: **10.04.2013**
(21) Application number: 06756197.7
(22) Date of filing: 06.06.2006
(51) Int. Cl.: G06F 12/00, G06F 13/00, G06F 13/28

(54) **FLASH MEMORY WITH PROGRAMMABLE ENDURANCE**
FLASHSPEICHER MIT PROGRAMMIERBARER DAUER
MEMOIRE FLASH PRESENTANT UNE ENDURANCE PROGRAMMABLE

(30) Priority: 08.06.2005 US 688233 P; 14.11.2005 US 271880
(43) Date of publication of application: 27.02.2008
(73) Proprietor: SanDisk IL Ltd, Kfar Saba 44425 (IL)
(72) Inventor: DARIEL, Dani, 76850IL Yishuvai Gderot (IL); LASSER, Menachem, 44864 Kohav Yair (IL)
(74) Representative: Cooper-Rolfe, Elizabeth Louise
(86) International application number: PCT/IL2006/000656
(87) International publication number: WO 2006/131915

(56) References cited:
- US-A- 5 345 413
- US-A- 5 345 413
- US-A- 5 737 742
- US-A- 5 737 742
- US-A1- 2003 189 858
- US-A1- 2004 213 070
- US-A1- 2005 144 361
- US-B1- 6 985 992

## Description

### FIELD OF THE INVENTION

The present invention relates to non-volatile memory devices such as flash memory devices.

### BACKGROUND OF THE INVENTION

### Non-Volatile Memory

Non-volatile memory is a type of memory that can retain its stored data without a power source. There are several types of non-volatile memories, differentiated by read, write and erase capabilities, access times, data retention, and data endurance cycles.
Electrically Erasable Programmable Read Only Memory (EEPROM) is capable of performing read write operations on a per-byte level, meaning each of the memory locations can be individually read and written.

Flash memory, comprised of flash-type floating-gate transistors, is a non-volatile memory similar in functionality and performance to EEPROM memory; flash memory has the advantage of being relatively inexpensive, although it operates under certain limitations. It is not possible to rewrite to a previously written location on flash memory without first erasing an entire memory section, i.e., the flash cells must be erased (e.g. programmed to "one") before they can be programmed again. Flash memory can only erase relatively large groups of cells, usually called erase blocks (typically 16 to 128KB in size for current commercial devices). Therefore updating the contents of a single byte or even a chunk of 1KB requires housekeeping operations - the parts of the erase block that are not updated must first be moved elsewhere so they will be preserved during the erase operation, and then moved back into place after the update.

US 5,737,742 discloses a memory system including a flash memory having a plurality of individually erasable physical blocks, table section for holding the relationship in correspondence between the logical blocks allocated by the allocation section and the physical blocks, first counting and managing section for counting and managing write counts of the respective logical blocks, first classifying section for classifying the logical blocks into a plurality of groups on the basis of the respective write counts of the logical blocks, erasure section for erasing data in a physical block allocated to a logical block to produce a free physical block, second counting and managing section for counting and managing the erasure counts of the respective physical blocks, second classifying section for classifying the physical blocks into a plurality of groups on the basis of the respective erasure counts of the physical blocks, control section for allocating the respective logical blocks to the physical blocks, and managing section for managing free physical blocks which are not allocated to any logical blocks. The allocation control section performs an exchanging process as required which comprises the steps of allocating a logical block belonging to a logical block group having a larger write count to a free physical block belonging to a physical block group having a smaller erasure count and allocating a logical block belonging to a logical block group having a smaller write count to a free physical block belonging to a logical block group having a larger erasure count, increasing the service life of the memory system by preventing requests from collecting in a particular sector.

Electrically erasable non-volatile memory suffers from wear when subjected to write and erase operations. Each memory location can withstand a limited number of write/erase cycles. Areas of the flash that are written to more than the specified number of times are unreliable, and data read from an overused location may be incorrect. The number of write operations a non-volatile memory area can withstand before becoming unreliable is called endurance. A typical endurance level is 100,000 write/erase cycles. The endurance level is guaranteed by the device manufacturer, and is a worst-case number, in practice, most of the cells contained in the flash memory are likely to withstand a much higher number of write/erase cycles.

Flash memory is further categorized into NOR and NAND flash, based on the type of memory cells interconnection architecture used. The cost per bit for NAND flash is lower than that of NOR flash. However, NAND flash memory is limited to block read and write operations, as compared to a NOR flash memory that is capable of read and possibly write operations at the byte level, provided that the written location is erased (i.e. it contains all "ones"). Furthermore, typical NAND flash memory contains a small portion of bad blocks, which are not reliable and should not be used to store data. Bad blocks are verified either by the manufacturer when initially testing the flash memory, or by software when detecting the failure of a block during use in the field.

To overcome these limitations of NAND flash memory, a Flash File System (FFS) has been developed. The FFS provides a system of data storage and manipulation on devices that contain flash memory and that emulate data storage on a magnetic disk Such FFS was disclosed in U.S. Pat. No. 5,937,425.
All three types of non-volatile memory (EEPROM, NOR flash, and NAND flash) are currently in use, and the specific type is determined by the application. NAND flash memory is used mainly where mass storage is required, but due to its block access nature, software applications cannot run directly from NAND flash. When software applications must be executed directly from a memory device, NOR flash memory should be used. EEPROM is used where a relatively small amount of memory is required and data will be written at the byte level.

It is noted that memory block devices may be logically divided into several partitions, similar to magnetic disk partitions. Each partition behaves as a separate logical unit or disk. The flash controller that implements the FFS is usually also responsible for managing the device partitioning.

With some applications, an EEPROM device may be emulated using NOR flash memory; the emulated EEPROM enables writing a single byte to the NOR memory and erasing the NOR memory block when required. Emulated EEPROM may be implemented by hardware, firmware, or a combination of the two.

With some applications, the limited endurance of flash memory may be problematic, for example, in an operating system that uses a block device as virtual memory. In order fo increase the amount of available Random Access Memory (RAM) for an application, the operating system may implement disk swapping. In disk swapping, the operating system saves some sections of its RAM to its mass storage device, and reloads the RAM data as soon as an application needs to access it. The mass storage area used as a swap area may have to withstand intensive read/erase/write or erase cycles, resulting in relatively high wear compared to other sections of the mass storage device that are used to store code or static data. Another example is a File (System) Allocation Table (FAT). The FAT is updated quite frequently, whenever a new file is created or the size of an existing file changes.

### Extending the Life Span of Non-Volatile Memory Devices

Most systems that contain NAND flash implement a wear-leveling algorithm. Wear-leveling algorithms optimize the number of write operations that can be performed on each flash memory block. According to this algorithm, each flash memory block gets written to roughly an equivalent number of times. When a logical block is translated into a physical block, the same logical block may be written to different physical locations. Thus, wear leveling algorithms can be useful, in many situations, for extending the life span of flash memory devices without concomitantly reducing the amount of logically addressable memory available on the device.

US 5,367,484 discloses an EEPROM device having a number of data storage blocks, where a selected block may be designated to provide "high endurance." This selected block is placed in parallel with a similar redundant block using a switching unit, whereupon identical data is written simultaneously to the two blocks. According to the disclosure of US 5,367,484, this redundancy increases the endurance of the selected blocks, because if only one of the selected block and the redundant block fails, it will still be possible to write data to the corresponding logical region. US 5,793,684 discloses that if high reliability and redundancy are subsequently not required, a signal may be sent to the switching unit to disconnect the address locations of the first memory array from the corresponding address locations of the redundant second memory array to produce a memory device having an increased amount of address locations. There is no disclosure or suggestion of increasing the endurance level of memory other than EEPROM. Furthermore, the aforementioned patents do not disclose how much additional endurance the "high" endurance level provides, and there is no disclosure or teaching of configuring non-volatile memory to provide a requested endurance.

US Patent Application 2003/0028733 discloses a memory apparatus having a volatile memory for storing data from a host, a nonvolatile memory capable of storing the data stored in the volatile memory, and electrically deleting the data, and a control circuit for controlling data transfer between the volatile memory and the nonvolatile memory. The memory device disclosed is a volatile memory device - e.g. a capacity of a data storage area of the volatile memory is larger than that of a data storage area of the nonvolatile memory. The device disclosed is volatile memory device having a relatively small non-volatile memory backup, and there is no disclosure of non-volatile memory devices as understood herein.

US 5,345,413 discloses an electrically erasable programmable semiconductor memory device having a user option to selectively configure the security, endurance, organization, density or protocol of the memory array of the device.

US 2004/0213070 A1 discloses a method of recording and reproducing information in which a recording area of a memory card is physically divided into small pages and is also partitioned into physical blocks each having a plurality of the pages so that information recorded in the page is erased in units of each block having the page. When an FAT area where information is changed frequently is allocated to a certain block, the FAT area is allocated to a page or pages in the block, and the remaining pages in the same block are made unavailable although they are unused.

There is an ongoing need for improved non-volatile devices and methods for configuring non-volatile memory devices to provide improved memory endurances. It is noted that prior knowledge of approximately how many write or erase cycles a memory portion or entire non-volatile memory may reliably sustain allows for appropriate planning and device utilization. Thus, there is an ongoing need for devices that are configurable to provide a specific requested memory endurance.

### SUMMARY OF THE INVENTION

According to a first aspect of the present invention there is provided a non-volatile memory system, comprising: a non-volatile memory device; and a controller operative to configure physical memory by allocating a plurality of blocks of physical memory for data operations for a logically addressable memory, wherein each block of the plurality of blocks of the physical memory has an amount of physical memory equal to a desired amount the logically addressable memory, and wherein each request for a write operation for a first specified location of the logically addressable memory is handled by, for each such write request, writing data once to a memory block of the plurality of blocks of the physical memory that was not previously written for the first specified location of the logically addressable memory; wherein the controller is further operative to configure the physical memory such that a first write request operation for the first specified location of the logically addressable memory is handled by writing data to a first location in a first block of the plurality of blocks of the physical memory, and each subsequent write request operation for the first specified location of the logically addressable memory is handled by writing data to a first location in a different one of the plurality of blocks of the physical memory until all but one of the blocks, namely a last block of the plurality of blocks of the physical memory, has been written with data for the first specified location of the logically addressable memory, and in that case, data from each of the first locations in the plurality of blocks of the physical memory that was previously written with data for the first specified location of the logically addressable memory is copied into the last block of the plurality of blocks of the physical memory, and the first locations of the plurality of memory blocks of the physical memory are erased.

According to a second aspect of the present invention there is provided a method of operating a non-volatile memory device, comprising: (a) identifying a desired amount of logically addressable memory; (b) configuring physical memory by allocating a plurality of blocks of physical memory for data operations for the logically addressable memory, wherein each block of the plurality of blocks of the physical memory has an amount of physical memory equal to the desired amount of the logically addressable memory, and wherein each request for a write operation for a first specified location of the logically addressable memory is handled by, for each such write request, writing data once to a memory block of the plurality of blocks of the physical memory that was not previously written for the first specified location of the logically addressable memory; (c) upon a first write operation for the first specified location of the logically addressable memory, writing data to a first location in a first block of the plurality of blocks of the physical memory; (d) upon each subsequent write operation for the first specified location of the logically addressable memory, for each such subsequent write operation, writing data to a first location in a different one of the plurality of blocks of the physical memory until all but one of the blocks, namely a last block of the plurality of blocks of the physical memory, has been written with data for the first specified location of the logically addressable memory, and in that case, copying data from each of the first locations in the plurality of blocks of the physical memory that was previously written with data for the first specified location of the logically addressable memory into the last block of the plurality of blocks of the physical memory; and (e) erasing the first locations of the plurality of memory blocks of the physical memory, then repeating steps (c) through (e) as required for the first specified location of the logically addressable memory.

There is now disclosed for the first time a non-volatile memory device including a non-volatile memory and a controller operative to configure at least a portion of the non-volatile memory to provide a requested effective endurance. According to some embodiments, the requested effective endurance exceeds a native physical endurance of the at least a portion of the non-volatile memory.

According to some embodiments, the configuring of the at least a portion by the controller includes the steps of determining an amount of physical non-volatile memory to reserve for the at least a portion, where the determined amount exceeds a logical size of the at least a portion, and allocating the determined amount of physical memory.

Thus, in one example, it is requested that a logically addressable memory portion (e.g. 20 MB of memory) be configured to have an effective endurance equal a multiple (e.g. an "endurance multiple") of the native physical memory (e.g. three). According to this specific example, a physical region of non-volatile memory (e.g. 60 MB of physical memory) is reserved to provide the requested effective endurance, and this physical region is subdivided into a number (e.g. three) of physical subregions equal to the endurance multiplier. In this specific example, the size of each subregion is identical to the size of the logically addressable memory portion (e.g. 20 MB of memory).

According to this example, a first request to write data to a specific logical address is handled by writing data to the appropriate location within a first subregion. Similarly, second and third requests to write data to the same specific logical address are handled by writing data to the respective locations in the second and third subregions. A fourth request to write data to the specific logical address is operative, once more, to write the data to the first subregion. Thus, in this example, by writing the data to different physical locations each time, any given physical location sustains a fraction (e.g. one divided by the endurance multiplier, or one third) of the number of write operations. Thus, the reserved region of physical memory, and concomitantly the logically addressable memory portions, provides the requested effective endurance.

Thus, according to some embodiments, each of a plurality of write operations to a given logical memory address is operative to write data to a different physical location in memory.

Furthermore, it is understood that according to the previous example, requesting an effective endurance that exceeds that native physical endurance (e.g. three times that physical endurance) results in 60 MB of physical memory being reserved for 20 MB of logical storage. Thus, it is noted that, according to this example, the total amount of logically addressable memory decreases (e.g. by the difference between 60 MB and 20 MB, or 40 MB) upon memory configuration.

According to some embodiments, the allocation of the extended storage per partition and the management of each partition in a non-random access flash memory device are typically implemented as part of the FFS, but may be implemented by external applications, and/or may be supported by hardware. After allocating the desired amount of physical memory, each partition is managed in a way that is similar to how it was managed without this invention.

Thus, according to some embodiments, a total amount of logically addressable memory decreases upon the configuring to provide the increased effective endurance.

According to some embodiments, for a given amount of configured physical memory, requesting a greater effective endurance provides a smaller amount of logically addressable memory.

Alternatively or additionally, for a given amount of logically addressable memory, requesting a greater effective endurance configures a greater amount of physical non-volatile memory.

According to some embodiments, the amount is determined in accordance with a specified value of the requested effective endurance.

According to some embodiments of the present invention, it is possible to program the endurance of the non-volatile memory to a variety of levels, where the desired endurance is a tradeoff between the logical memory size and the extra endurance, so a minimum desired endurance level is provided or guaranteed.

According to some embodiments, the controller is operative to set the effective endurance to one of a plurality of values.

There is no limitation on how the effective endurance is requested. According to some embodiments, the controller is operative to configure the non-volatile memory in accordance with received parameters provided with an external command (e.g. a formatting command).

According to some embodiments, the device further includes an interface for receiving a value of requested effective endurance. In particular, according to some embodiments, the user interface for initializing the flash memory is enhanced and includes an entry for specifying the desired endurance level per each defined partition.

There is no limitation on the type of non-volatile memory to be configured in accordance with embodiments of the present invention, and it is noted that configuration of random access memory and configuration of non-random access memory to provide an effective endurance are both within the scope of the present invention. Appropriate non-volatile memory includes but is not limited to NAND flash memory, NOR flash memory and EEPROM memory. Nevertheless, it is noted that in various embodiments, the specific algorithm used to configure to provide the effective endurance may vary, depending on the type of non-volatile memory.

According to some embodiments, the device is operative to emulate EEPROM memory.

According to some embodiments, the controller is operative to configure all of the non-volatile memory to provide the requested effective endurance.

According to some embodiments, the controller is operative to write data to the allocated physical memory, and at least one writing includes writing given data only once to the allocated physical memory.

According to some embodiments, the controller is operative to set the effective endurance to a first value for a first portion of the non-volatile memory, and is operative to set the effective endurance to a second value different from the first value for a second portion of the non-volatile memory.

According to some embodiments, the controller includes embedded software and the configuring is effected at least in part by the embedded software.

Although certain embodiments of the present invention have been explained in terms of a memory device controller configuring the non-volatile memory to provide the requested effective endurance, this is not a limitation of the present invention. The memory configuration can be implemented by hardware, software, firmware, or any combination thereof, residing on any device or devices. The memory configuration can be applied to off the-shelf memory devices by enhancing the control firmware or to the glue logic connecting the device to the processing unit or bus.

It is now disclosed for the first time a system for data storage including a non-volatile memory device including a non-volatile memory, a host device coupled to the non-volatile memory device and driver code residing on the host device, where the driver code operative to configure at least a portion of the non-volatile memory to provide a requested effective endurance.

It is now disclosed for the first time method for setting an effective memory endurance. The presently disclosed method includes issuing a command to set an effective endurance of a non-volatile memory device including non-volatile memory and configuring at least a portion of the non-volatile memory to provide the requested effective endurance.

According to some embodiments, the command is an external command issued by a host device coupled to the non-volatile memory device.

According to some embodiments, the effective endurance exceeds a physical endurance of the at least a portion of the non-volatile memory.

According to some embodiments, the configuring includes reducing a total amount of logically addressable memory of the non-volatile memory device.

According to some embodiments, the effective endurance is set at the time of manufacture or a time of formatting of the non-volatile memory device.

According to some embodiments, the effective endurance is set at a runtime of the non-volatile memory device.

According to some embodiments, the setting of the effective endurance is effected at least in part by software embedded within the non-volatile memory device.

According to some embodiments, the setting of the effective endurance is effected at least in part by software residing on a host computer coupled to the non-volatile memory device.

It is now disclosed for the first time computer readable storage medium having computer readable code embodied in the computer readable storage medium, the computer readable code comprising instructions to configure at least a portion of a non-volatile memory of a non-volatile memory device to provide a requested effective endurance.

These and further embodiments will be apparent from the detailed description and examples that follow.

### BRIEF DESCRIPTION OF THE DRAWINGS

Figure 1A provides a block diagram of an exemplary non-volatile memory device according to exemplary embodiments of the present invention.
Figure 1B illustrates an exemplary implementation of a device partitioning routine of non-random access memory such as NAND flash to provide an effective endurance.
Figure 2 provides a flow chart of an exemplary routine wherein at least a portion of a non-volatile memory is configured to provide a specified endurance.
Figure 3 provides a simplified flowchart of an exemplary flash memory management algorithm.
Figure 4 illustrates an exemplary implementation of a routine for configuring non NOR flash to provide an effective endurance.
Figure 5 is a flowchart that describes a write operation to a random access device according to exemplary embodiments of the present invention.
Figure 6 describes an exemplary read process.
Figure 7 illustrates an exemplary hardware implementation of the mapping table.

### DETAILED DESCRIPTION OF THE INVENTION

The present invention will now be described in terms of specific, example embodiments. It is to be understood that the invention is not limited to the example embodiments disclosed. It should also be understood that not every feature of the non-volatile memory devices operative to configure memory to provide a requested effective endurance, systems for data storage, methods for setting effective memory endurance, and computer readable code described is necessary to implement the invention as claimed in any particular one of the appended claims. Various elements and features of devices are described to fully enable the invention. It should also be understood that throughout this disclosure, where a process or method is shown or described, the steps of the method may be performed in any order or simultaneously, unless it is clear from the context that one step depends on another being performed first.

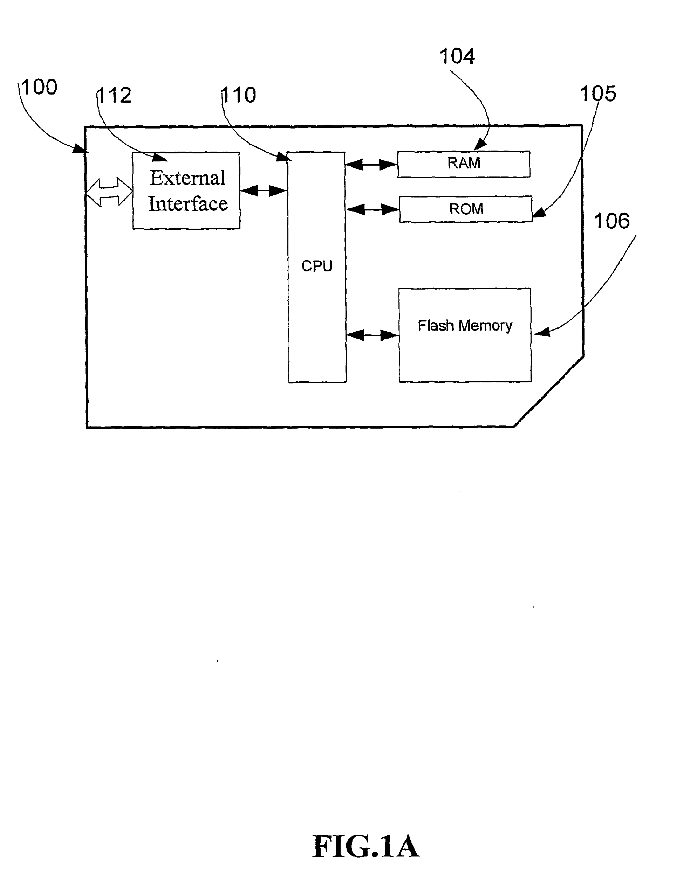

Figure 1A provides a block diagram of an exemplary non-volatile memory device (100) according to exemplary embodiments of the present invention. According to Figure 1A, data and commands are received from a host device (note shown) through an external interface (112). A central processing unit (110) stores data in non-volatile memory (e.g. flash memory (106)) of the device. The CPU (110) makes use of ROM and volatile memory (e.g. the RAM (104)) when managing the device. Because the volatile memory is primarily used for device management and not for data storage, the size of the volatile memory is typically much smaller (e.g. at least one order of magnitude) than the size of the non-volatile memory.

Throughout this disclosure, "a non-volatile memory device" refers to a device where a majority of the memory provided in the device is non-volatile memory. Examples of non-volatile memory devices include smartcard devices, memory cards, MultiMediaCards and the like. In some embodiments, a "non-volatile memory device" includes both volatile and non-volatile memory, and a ratio between size of the non-volatile memory and a size of the volatile memory is, for example, at least 10, or, for example, at least 100.

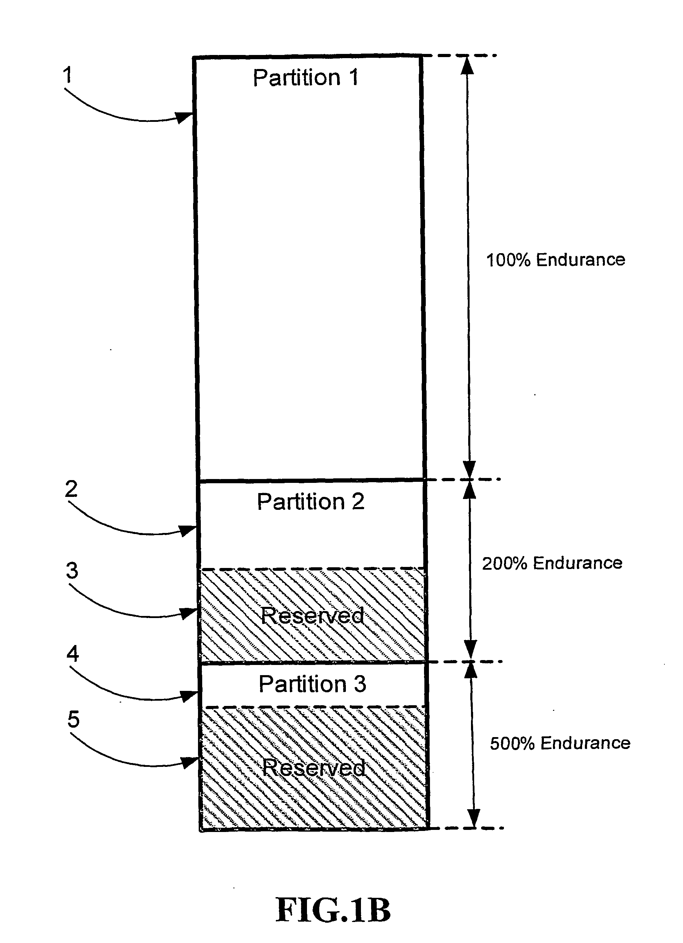

Figure 1B illustrates an exemplary implementation of a routine for configuring non-random access memory such as NAND flash to provide an effective endurance. According to this example, the memory is divided into three portions. The first partition (1) is used to store mostly static data; as there is no requirement for enhanced endurance, this memory partition is managed using legacy means. The second partition (2) is used for more dynamic data storage (e.g. database storage), so its desired endurance is higher then the native memory endurance, 200% in this example. In order to ensure higher endurance, the physical memory size assigned for this partition is twice the logical size. A reserved area (3) is added to this partition; the reserved area size is the same size as the size of the required area so we achieve a minimum endurance level of 200% (see the explanation below for calculating the minimum endurance).

A third memory partition (4) is defined in a way similar to the previous partition (2), but with this third partition the required endurance is five times the nominal endurance, the physical memory size is 5 times the logical area, and the reserved area (5) is 4 times the required capacity. Since the flash management application writes to a different location each time, the endurance of this partition is guaranteed to be at least 5 times the minimum native device endurance.

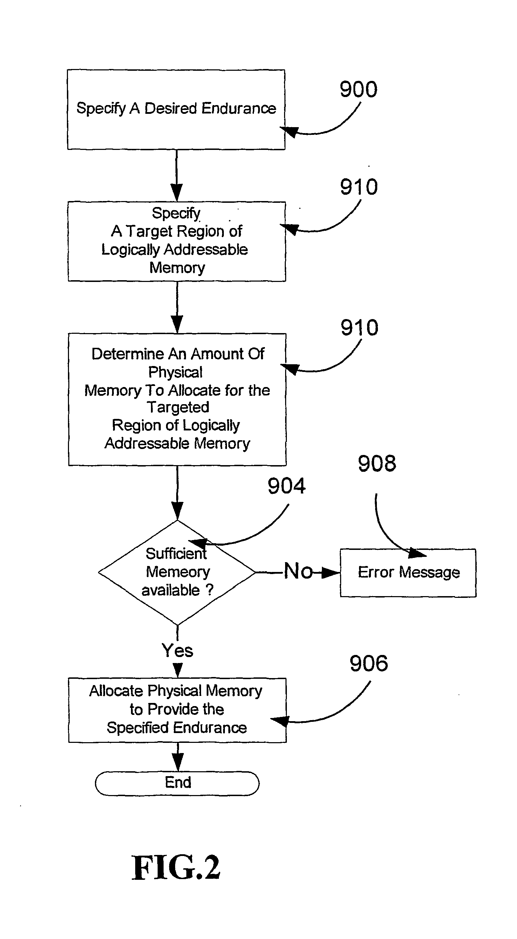

Figure 2 provides a flow chart of an exemplary routine wherein at least a portion of a non-volatile memory is configured to provide a specified endurance. According to the example of Figure 2, an effective endurance is specified (900) (for example, by a user operating a host device coupled to the memory device) for a specified (910) target region of logically addressable memory. It is noted that the effective endurance can be specified (900) in a number of ways. In one non-limiting example, an "endurance multiplier," indicative of a ratio between the requested endurance and the native endurance, is specified.

It is intended to configure the device so that it is possible to reliably write to addresses within the target region of logically addressable memory (910) at least a number of times as specified by the effective endurance (900). Towards this end, a determination (902) is made (for example, by firmware of the non-volatile memory device) of how much physical memory needs to be allocated for the targeted region of logically addressable memory. There is no limitation on how this determination is made (902), and any technique known in the art is appropriate for these embodiments of the present invention (e.g. by computing this number from the specified effective endurance and the size of the target region of logically addressable memory, using a lookup table, etc.).

In the event that enough physical memory is available (904), the device controller allocates (906) the physical memory to provide the specified endurance (906) - e.g. where the physical memory size is the logical size multiplied by the ratio of the desired endurance (900) divided by the device native endurance.

If insufficient physical memory is available (904), an error message (906) is optionally generated and, for example, transmitted to the host device. According to some embodiments, as soon as the system writes to the device, the device control searches for the next free area and maps the logical block or memory location to a physical location that stores the data. The logical-to-physical map is kept in a mapping table that can be a hardware-based memory map or implemented by firmware. The mapping table is backed up in a special section of the non-volatile memory and reloaded at power-up time.

The following paragraphs provide a detailed description of the method as applicable for each major type of non-volatile memory.

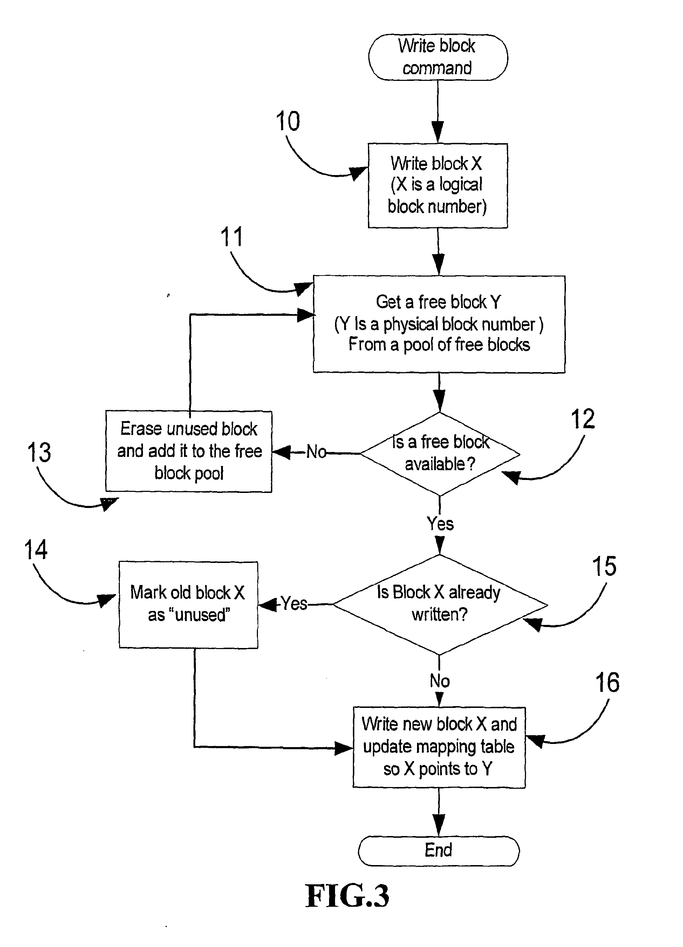

Figure 3 provides a simplified flowchart of an exemplary flash memory management algorithm; this simplified flow is used to illustrate the providing of increased endurance. In practice, a more sophisticated algorithm such as the one described in U.S. Pat. No. 5,937,425 may also be implemented. A write block command (10) specifies a logical block number X to be written to the flash memory. In order to write this block, the flash management logic allocates a free block from a pool of free blocks. This free block number has a physical address Y (11). If the list of free blocks is empty (12) the flash management searches the memory for an unused block, erases it, and adds it to the list of free blocks (13). With some flash management implementations, more than one free block may be erased at the same time, and in other implementations the erase may be performed as a background operation. The flash management verifies if the logical block X has been already written, meaning whether it has already been mapped to a physical block (15). If yes, the old physical block is marked as "unused" (14), and is added to the list of free blocks as soon as it is erased. Finally, the logical block X is written to physical location Y and the mapping table is updated so logical block X points to Y (16).

If the amount of physical memory allocated to a partition is y and the logical partition size is x, by writing n times to the flash memory each location will be written n x (x ÷ y) times on average. As long as free blocks are available, these blocks will be used for storing new data. As a result, if the flash memory endurance is e write or erase cycles, the minimum new endurance level will be el = e ÷ (x ÷ y). For example, assume that y = 20 and x = 10. Initially, all blocks are free so writing to logical blocks 0-9 causes the FFS write to physical blocks 0-9. If data is written to logical blocks 0-9 again, the FFS will write the data to physical blocks 10-19. So far, each physical block has been written once, while each logical block has been written twice. If we repeat this process over and over, the wear of the logical memory is double the wear of the native physical memory, or we can say that the endurance is doubled. Assuming that e = 10,000, using the above formula to calculate the average logical endurance results 10,000 ÷ (10 ÷ 20) = 20,000, which is twice the native physical memory endurance. In practice, the actual endurance will be much higher than the minimum calculated endurance because as soon as a block is worn out, it is put aside (marked as a bad block) and not used any more. Since there are many redundant blocks, the flash memory is usable as long as the physical amount of memory is larger then the logical memory size. As soon as the amount of the physical memory falls below a certain level, a warning message may be generated to warn the user that the memory device must be replaced. The extra endurance we may get due to bad block detection is highly dependent on the nature of the application using the flash memory and the properties of the device. With typical devices this extra endurance may add up to ten times the native device endurance where the physical memory size is only twice of the logical size.

A similar method can be implemented for NOR flash. Unlike NAND flash, NOR flash read is similar to random access, read-only memory. In exemplary embodiments, the implementation of configurable endurance for NOR flash memory includes a software layer to receive read/write requests and perform the physical read/write operations. By implementing some of the logic in hardware, it may be possible to read directly from the memory device and to execute applications directly from the NOR flash memory.

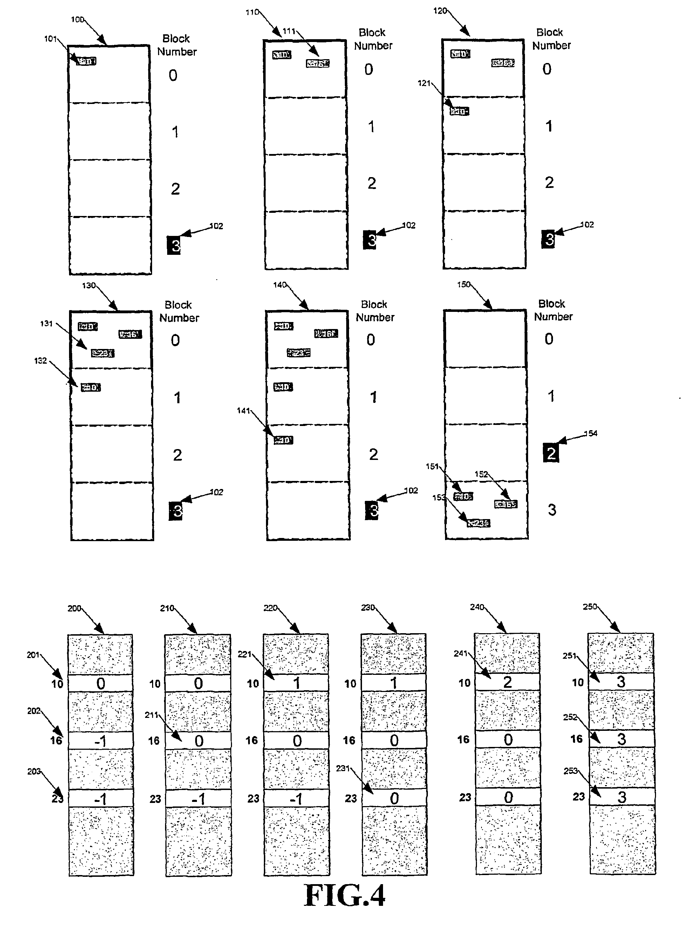

Figure 4 illustrates an exemplary implementation of a routine for configuring NOR flash to provide an effective endurance. Subfigures (100), (110), (120), (130), (140) and (150) illustrate different states of the NOR flash memory contents while sub-figures (200), (210), (220), (230), (240) and (250) describe the corresponding states of the address mapping table. A section of the NOR flash memory (101) that needs a higher endurance level is divided into four sections numbered 0, 1, 2 and 3. The size of each of the four sections is set equal to the desired size of the logical memory. In this example, the physical memory is four times larger than the size of the logical memory. Initially, all blocks are erased. In this example, we want to write new data to logical memory location 10. Since memory block 0 is erased the data is written to block 0 (101), and 0 is also recorded in a mapping table (200) at location 10 (201), meaning logical location 10 mapped to block 0. All other mapping table locations are initially set to -1 (202), (203), which indicates that these entries are not in use. Writing to a new location (111) is performed similarly and the mapping table (211) is updated accordingly. As soon as logical address 10 needs to be written again, it is written to the next physical block (121) and the mapping table is updated accordingly (221). If data is written to a new location that has not been written previously, block 0 is used (131). Writing location 10 again will set the block number of this address to 2 (141), (241). After writing location 10 to the first 3 blocks, the next time address 10 is written (150), all the data from all previously written locations is copied to the forth block (102) and the first 3 blocks are erased (151), (152), (153) to make room for new data. The mapping table is updated accordingly (251), (252), (253). Up until this point, block 3 has been last and block 0 has been first; after the data is copied, the block order is rearranged as 3,0,1,2 so that block 3 is now first and block 2 is last (154).

When a memory read operation is performed, the memory map is first read and the block number related to the desired location is extracted. The data is then read from the block number to which the mapping table points.

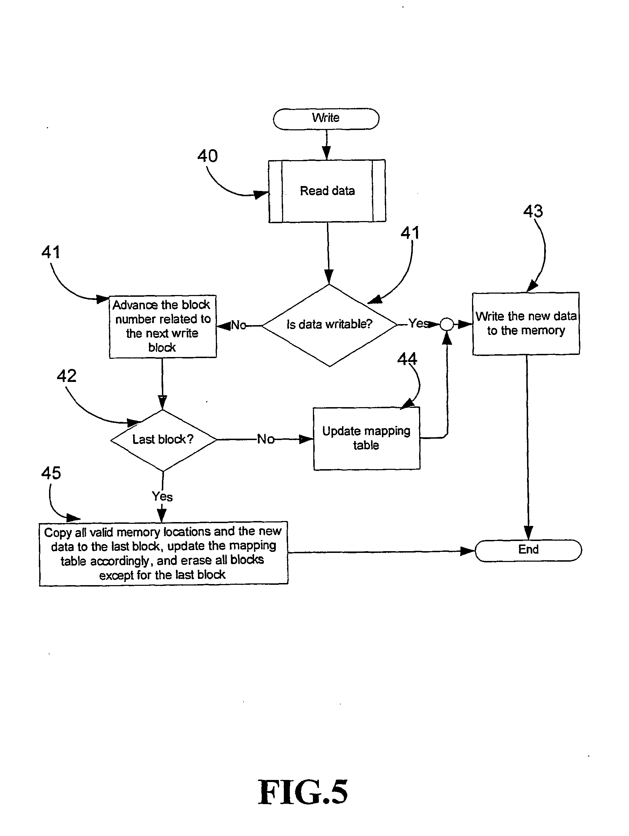

Figure 5 is a flowchart that describes a write operation to a random access device according to exemplary embodiments of the present invention. The write process starts with the FFS reading the relevant memory location (40) and testing if this location is writable (41). A memory location is writable if the new data does not require setting any of its bits from "0" to "1", for example, an erased area of memory contains all ones so it is always writable. A memory byte that has been written with hex F0 may be changed to 00, but not to FF. If the data is writable, the new data is written to the desired location (43), otherwise the FFS advances the current block number (42) and checks whether it is the last block (42). If it is not the last block, the mapping table is updated (44), and then the FFS writes the data to memory. Since the new block is erased, this logical location within the next block is writable. If this is the last block, all previously written data from all other blocks is copied to the last block, all memory blocks except for the last block are erased, and the mapping table is updated so all logical addresses point to the last memory block (45).

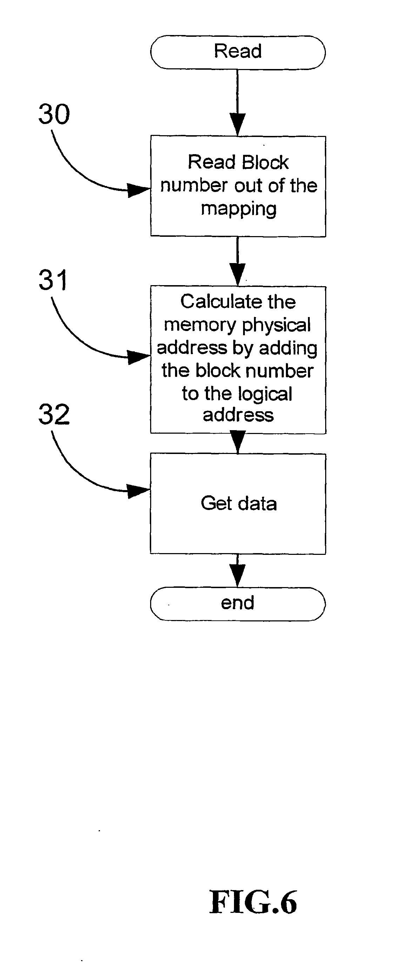

Figure 6 describes an exemplary read process. According to embodiments illustrated in FIG. 6, in order to read a memory location, the FFS first reads the mapping table and gets the relevant block number (30), and then the physical memory address is calculated by combining the logical address with the block number (31). After this calculation, the desired data is read (32).

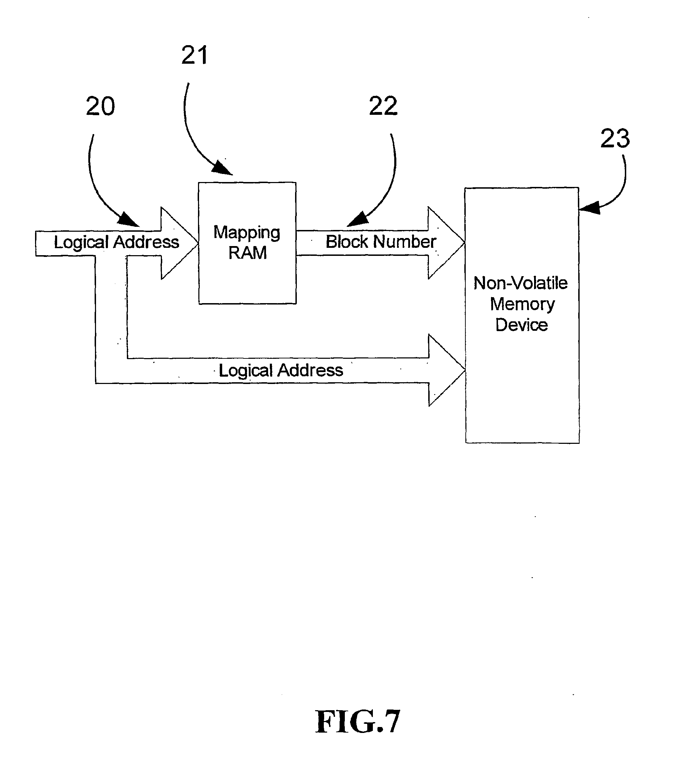

Figure 7 illustrates an exemplary hardware implementation of the mapping table. A mapping RAM (21) is used to store the block number for each memory location. The logical address (20) is applied to the mapping RAM address bus, and the data bus of the mapping RAM provides the block number as the high address bits (22) to the non-volatile memory (23). Hardware implementation of the mapping RAM provides a fast read access time and preserves the NOR flash property of executing code directly from memory.

In order to reduce the size of mapping table, several memory addresses might be grouped together. For example, every 32 consecutive memory addresses can be grouped, which reduces the mapping table size by 1/32 so there are five less mapping RAM address bits (the five Least Significant address bits are not applied to the mapping RAM). The previously described algorithm works almost the same way, except that every time the block number changes all valid memory locations that belong to the same group must be copied to the next block. For example, if the group size is 32 bytes, writing a second time to memory location 35 will require copying memory locations 32-34 and 36-63 (all belonging to the same group) to the next block.

The same method is also applicable for EEPROM, except that there is no need to perform erase before write. As such, each time the same logical memory location is updated, the data is written to the next memory block.

Calculating the new endurance for a random access device is the same as explained previously for a non-random access device. As with the non-random access device, the minimum guaranteed endurance is in direct proportion to the ratio of the physical memory size and the logical memory size.

In the description and claims of the present application, each of the verbs, "comprise" "include" and "have", and conjugates thereof, are used to indicate that the object or objects of the verb are not necessarily a complete listing of members, components, elements or parts of the subject or subjects of the verb.

The present invention has been described using detailed descriptions of embodiments thereof that are provided by way of example and are not intended to limit the scope of the invention. The described embodiments comprise different features, not all of which are required in all embodiments of the invention. Some embodiments of the present invention utilize only some of the features or possible combinations of the features. Variations of embodiments of the present invention that are described and embodiments of the present invention comprising different combinations of features noted in the described embodiments will occur to persons of the art. The scope of the invention is limited only by the following claims.

## Claims

1. A non-volatile memory system (100) comprising:
a non-volatile memory (106) device, and
a controller (110) operative to configure physical memory by allocating (906) a plurality of blocks of physical memory for data operations for a logically addressable memory, wherein each block of the plurality of blocks of the physical memory has an amount of physical memory equal to a desired amount of the logically addressable memory, and wherein each request for a write operation for a first specified location of the logically addressable memory is handled by, for each such write request, writing data once to a memory block of the plurality of blocks of the physical memory that was not previously written for the first location of the logically addressable memory;
wherein the controller is further operative to configure the physical memory such that a first write request operation for the first specified location of the logically addressable memory is handled by writing data (43) to a first location in a first block of the plurality of blocks of the physical memory, and each subsequent write request operation for the first specified location of the logically addressable memory is handled by writing data (43) to a first location in a different one of the plurality of blocks of the physical memory until all but one of the blocks, namely a last block of the plurality of blocks of the physical memory, has been written with data for the first specified location of the logically addressable memory, and in that case, data from each of the first locations in the plurality of blocks of the physical memory that was previously written with data for the first specified location of the logically addressable memory is copied (45) into the last block of the plurality of blocks of the physical memory, and the locations of the plurality of memory blocks of the physical memory are erased (45).

2. The non-volatile memory system of claim 1, said controller being further operative to configure the physical memory such that each request for a write operation for a second location of the logically addressable memory is handled by, for each such write request, writing data once to a memory block of the plurality of blocks of the physical memory not previously written for the second location of the logically addressable memory.

3. The non-volatile memory system of any of claims 1 to 2, said controller being further operative to specify an effective endurance for the plurality of blocks of physical memory, whereby the effective endurance exceeds a native endurance associated with the physical memory, and wherein a total number of the plurality of blocks of the physical memory allocated is proportional to a ratio of the effective endurance to the native endurance.

4. The non-volatile memory system of any of claims 1 to 3, said controller being further operative to map (44) a location of the logically addressable memory to one or more locations in the plurality of blocks of the physical memory after each write operation.

5. The non-volatile memory system of any of claims 1 to 4, further comprising:
an interface (112) for receiving a value for an effective endurance for the plurality of blocks of the physical memory.

6. The non-volatile memory system of any of claims 1 to 5, said controller being further operative to set different effective endurance values for different portions of the non-volatile memory.

7. The non-volatile memory system of any of claims 1 to 6, wherein said controller is further operative to reduce the amount of the logically addressable memory to achieve a specified effective endurance.

8. The non-volatile memory system of any of claims 1 to 7, wherein said controller is further operative to increase the amount of the logically addressable memory to achieve a specified effective endurance.

9. A method of operating a non-volatile memory device (106), comprising:
(a) identifying (910) a desired amount of logically addressable memory;
(b) configuring physical memory by allocating (906) a plurality of blocks of physical memory for data operations for the logically addressable memory, wherein each block of the plurality of blocks of the physical memory has an amount of physical memory equal to the desired amount of the logically addressable memory, and wherein each request for a write operation for a first specified location of the logically addressable memory is handled by, for each such write request, writing data once to a memory block of the plurality of blocks of the physical memory that was not previously written for the first specified location of the logically addressable memory;
(c) upon a first write operation for the first specified location of the logically addressable memory, writing data (43) to a first location in a first block of the plurality of blocks of the physical memory;
(d) upon each subsequent write operation for the first specified location of the logically addressable memory, for each such subsequent write operation, writing data (43) to a first location in a different one of the plurality of blocks of the physical memory until all but one of the blocks, namely a last block of the plurality of blocks of the physical memory, has been written with data for the first specified location of the logically addressable memory, and in that case, copying data (45) from each of the first locations in the plurality of blocks of the physical memory that was previously written with data for the first specified location of the logically addressable memory into the last block of the plurality of blocks of the physical memory; and
(e) erasing (45) the first locations of the plurality of memory blocks of the physical memory, then repeating steps (c) through (e) as required for the first specified location the logically addressable memory.

10. The method of claim 9, further comprising:
prior to configuring the physical memory, specifying (900) an effective endurance for the plurality of blocks of the physical memory, whereby the effective endurance exceeds a native endurance associated with the physical memory, and wherein a total number of the plurality of blocks of the physical memory allocated is proportional to a ratio of the effective endurance to the native endurance.

11. The method of any of claims 9 to 10, further comprising:
after each write operation, mapping (44) the first specified location of the logically addressable memory to one or more first locations in the plurality of blocks of the physical memory.

12. The method of any of claims 9 to 11, further comprising:
(f) upon a first write operation for a second specified location of the logically addressable memory, writing data (43) to a second location in the first block of the physical memory;
(g) upon each subsequent write operation for the second specified location of the logically addressable memory, for each such subsequent write operation, writing data (43) to a second location in a different one of the plurality of blocks of the physical memory until all but one of the blocks, namely a last block of the plurality of blocks of the physical memory, has been written with data for the second specified location of the logically addressable memory, and in that case, copying data (45) from each second location in the plurality of blocks of the physical memory that was previously written with data for the second specified location of the logically addressable memory into the last block of the plurality of blocks of the physical memory; and
(h) erasing (45) the second locations of the plurality of memory blocks of the physical memory, then repeating steps (f) through (h) as required for the second specified location of the logically addressable memory.

13. The method of any of claims 9 to 12, said specifying step comprising:
receiving an external command that specifies an effective endurance.

14. A computer readable storage medium having executable instructions for performing the method recited in any one of claims 9 to 13.

## Patentansprüche

1. Nicht flüchtiges Speichersystem (100), umfassend:
eine nicht flüchtige Speichervorrichtung (106); und
einen Controller (110), betreibbar zum Konfigurieren eines physikalischen Speichers durch das Zuweisen (906) einer Anzahl Blöcke des physikalischen Speichers für Datenoperationen eines logisch adressierbaren Speichers, wobei jeder Block der Anzahl Blöcke des physikalischen Speichers eine Größe des physikalischen Speichers aufweist, die gleich einer gewünschten Größe des logisch adressierbaren Speichers ist, und wobei jede Anforderung für einen Schreibvorgang für einen ersten spezifizierten Ort des logisch adressierbaren Speichers behandelt wird, und zwar für jede derartige Schreibanforderung, durch das einmalige Schreiben von Daten in einen Speicherblock der Anzahl Blöcke des physikalischen Speichers, der bisher nicht als erster spezifizierter Ort des logisch adressierbaren Speichers beschrieben wurde,
wobei der Controller zudem dafür betreibbar ist, den physikalischen Speicher so zu konfigurieren, dass ein erster Schreibanforderungsvorgang für den ersten spezifizierten Ort des logisch adressierbaren Speichers gehandhabt wird durch das Schreiben von Daten (43) an einen ersten Ort in einem ersten Block der Anzahl Blöcke des physikalischen Speichers, und jeder nachfolgende Schreibanforderungsvorgang für den ersten spezifizierten Ort des logisch adressierbaren Speichers gehandhabt wird durch das Schreiben von Daten (43) an einen ersten Ort in einem anderen Block der Anzahl Blöcke des physikalischen Speichers, bis alle Blöcke bis auf einen, nämlich den letzten Block der Anzahl Blöcke des physikalischen Speichers, mit Daten für den ersten spezifizierten Ort des logisch adressierbaren Speichers beschrieben worden sind, und in diesem Fall Daten von jedem der ersten Orte in der Anzahl Blöcke des physikalischen Speichers, die vorher mit Daten für den ersten spezifizierten Ort des logisch adressierbaren Speichers beschrieben wurden, in den letzten Block der Anzahl Blöcke des physikalischen Speichers kopiert (45) werden, und die ersten Orte der Anzahl Speicherblöcke des physikalischen Speichers gelöscht (45) werden.

2. Nicht flüchtiges Speichersystem nach Anspruch 1, wobei der Controller zudem dafür betreibbar ist, den physikalischen Speicher so zu konfigurieren, dass jede Anforderung für einen Schreibvorgang für einen zweiten Ort des logisch adressierbaren Speichers gehandhabt wird, und zwar für jede derartige Schreibanforderung, durch das einmalige Schreiben von Daten auf einen Speicherblock der Anzahl Blöcke des physikalischen Speichers, der bisher noch nicht als zweiter Ort des logisch adressierbaren Speichers beschrieben wurde.

3. Nicht flüchtiges Speichersystem nach irgendeinem der Ansprüche 1 bis 2, wobei der Controller zudem dafür betreibbar ist, eine effektive Beständigkeit für die Anzahl Blöcke des physikalischen Speichers zu spezifizieren, und die effektive Beständigkeit eine ursprüngliche Beständigkeit übersteigt, die dem physikalischen Speicher zueigen ist, und wobei eine Gesamtanzahl der zugewiesenen Blöcke des physikalischen Speichers proportional zu einem Verhältnis der effektiven Beständigkeit zur ursprünglichen Beständigkeit ist.

4. Nicht flüchtiges Speichersystem nach irgendeinem der Ansprüche 1 bis 3, wobei der Controller ferner dafür betreibbar ist, nach jedem Schreibvorgang einen Ort des logisch adressierbaren Speichers auf einen oder mehrere Orte in der Anzahl Blöcke des physikalischen Speichers abzubilden (44).

5. Nicht flüchtiges Speichersystem nach irgendeinem der Ansprüche 1 bis 4, weiterhin umfassend:
eine Schnittstelle (112), die einen Wert für eine effektive Beständigkeit für die Anzahl Blöcke des physikalischen Speichers empfängt.

6. Nicht flüchtiges Speichersystem nach irgendeinem der Ansprüche 1 bis 5, wobei der Controller ferner dafür betreibbar ist, unterschiedliche effektive Beständigkeitswerte für unterschiedliche Abschnitte des nicht flüchtigen Speichers einzustellen.

7. Nicht flüchtiges Speichersystem nach irgendeinem der Ansprüche 1 bis 6, wobei der Controller ferner dafür betreibbar ist, die Größe des logisch adressierbaren Speichers zu verringern, damit man eine spezifizierte effektive Beständigkeit erhält.

8. Nicht flüchtiges Speichersystem nach irgendeinem der Ansprüche 1 bis 7, wobei der Controller ferner dafür betreibbar ist, die Größe des logisch adressierbaren Speichers zu vergrößern, damit man eine spezifizierte effektive Beständigkeit erhält.

9. Verfahren zum Betreiben einer nicht flüchtigen Speichervorrichtung (106), umfassend:
a) das Kennzeichnen (910) einer gewünschten Größe des logisch adressierbaren Speichers;
b) das Konfigurieren des physikalischen Speichers durch das Zuweisen (906) einer Anzahl Blöcke des physikalischen Speichers für Datenoperationen des logisch adressierbaren Speichers, wobei jeder Block der Anzahl Blöcke des physikalischen Speichers eine Größe des physikalischen Speichers aufweist, die gleich der gewünschten Größe des logisch adressierbaren Speichers ist, und wobei jede Anforderung für einen Schreibvorgang für einen ersten spezifizierten Ort des logisch adressierbaren Speichers behandelt wird, und zwar für jede derartige Schreibanforderung, durch das einmalige Schreiben von Daten in einen Speicherblock der Anzahl Blöcke des physikalischen Speichers, der bisher nicht als erster spezifizierter Ort des logisch adressierbaren Speichers beschrieben wurde;
c) daraufhin bei einem ersten Schreibvorgang für den ersten spezifizierten Ort des logisch adressierbaren Speichers das Schreiben von Daten (43) an einen ersten Ort in einem ersten Block der Anzahl Blöcke des physikalischen Speichers;
d) daraufhin bei jedem nachfolgenden Schreibvorgang für den ersten spezifizierten Ort des logisch adressierbaren Speichers für jeden nachfolgenden Schreibvorgang das Schreiben von Daten (43) an einen ersten Ort in einem anderen Block der Anzahl Blöcke des physikalischen Speichers, bis alle Blöcke bis auf einen, nämlich den letzten Block der Anzahl Blöcke des physikalischen Speichers, mit Daten für den ersten spezifizierten Ort des logisch adressierbaren Speichers beschrieben worden sind, und in diesem Fall das Kopieren (45) von Daten von jedem der ersten Orte in der Anzahl Blöcke des physikalischen Speichers, die vorher mit Daten für den ersten spezifizierten Ort des logisch adressierbaren Speichers beschrieben wurden, in den letzten Block der Anzahl Blöcke des physikalischen Speichers; und
e) das Löschen (45) der ersten Orte der Anzahl Speicherblöcke des physikalischen Speichers, und anschließend das Wiederholen der Schritte c) bis e) nach Bedarf für den ersten spezifizierten Ort des logisch adressierbaren Speichers.

10. Verfahren nach Anspruch 9, ferner umfassend:
vor dem Konfigurieren des physikalischen Speichers das Spezifizieren (900) einer effektiven Beständigkeit für die Anzahl Blöcke des physikalischen Speichers, wobei die effektive Beständigkeit eine ursprüngliche Beständigkeit übersteigt, die dem physikalischen Speicher zueigen ist, und wobei eine Gesamtanzahl der zugewiesenen Blöcke des physikalischen Speichers proportional zu einem Verhältnis der effektiven Beständigkeit zur ursprünglichen Beständigkeit ist.

11. Verfahren nach irgendeinem der Ansprüche 9 bis 10, zudem umfassend:
nach jedem Schreibvorgang, das Abbilden (44) des ersten spezifizierten Orts des logisch adressierbaren Speichers auf einen oder mehrere Orte in der Anzahl Blöcke des physikalischen Speichers.

12. Verfahren nach irgendeinem der Ansprüche 9 bis 11, zudem umfassend:
f) daraufhin bei einem ersten Schreibvorgang für einen zweiten spezifizierten Ort des logisch adressierbaren Speichers, das Schreiben (43) von Daten an einen zweiten Ort im ersten Block des physikalischen Speichers;
g) daraufhin bei jedem nachfolgenden Schreibvorgang für den zweiten spezifizierten Ort des logisch adressierbaren Speichers für jeden derartigen nachfolgenden Schreibvorgang das Schreiben (43) von Daten an einen zweiten Ort in einem unterschiedlichen Block der Anzahl Blöcke des physikalischen Speichers, bis alle Blöcke bis auf einen, nämlich den letzten Block der Anzahl Blöcke des physikalischen Speichers, mit Daten für den zweiten spezifizierten Ort des logisch adressierbaren Speichers beschrieben worden sind, und in diesem Fall das Kopieren (45) von Daten von jedem der zweiten Orte in der Anzahl Blöcke des physikalischen Speichers, die vorher mit Daten für den zweiten spezifizierten Ort des logisch adressierbaren Speichers beschrieben wurden, in den letzten Block der Anzahl Blöcke des physikalischen Speichers; und
h) das Löschen (45) der zweiten Orte der Anzahl Blöcke des physikalischen Speichers, und anschließend das Wiederholen der Schritte f) bis h) nach Bedarf für den zweiten spezifizierten Ort des logisch adressierbaren Speichers.

13. Verfahren nach irgendeinem der Ansprüche 9 bis 12, wobei der Spezifizierungsschritt umfasst:
das Empfangen eines externen Befehls, der eine effektive Beständigkeit spezifiziert.

14. Computerlesbares Speichermedium, das ausführbare Anweisungen enthält, die das Verfahren nach irgendeinem der Ansprüche 9 bis 13 ausführen.

## Revendications

1. Système de mémoire non volatile (100), comprenant :
un dispositif de mémoire non volatile (106) et
un dispositif de commande (110) apte à configurer une mémoire physique par l'attribution (906) d'une pluralité de blocks d'une mémoire physique pour des opérations de données pour un mémoire adressable logiquement, où chaque bloc de la pluralité de blocks de la mémoire physique possède une quantité de mémoire physique égale à une quantité souhaitée de la mémoire adressable logiquement, et où chaque requête pour une opération d'écriture pour un premier emplacement spécifié de la mémoire adressable logiquement est gérée par, pour chaque requête d'écriture de ce type, en écrivant des données une fois sur un bloc de mémoire de la pluralité de blocs de la mémoire physique sur lequel n'a pas été écrit précédemment pour le premier emplacement spécifié de la mémoire adressable logiquement ;
où le dispositif de commande est en outre apte à configurer la mémoire physique de telle sorte qu'une première opération de requête d'écriture pour le premier emplacement spécifié de la mémoire adressable logiquement est gérée en écrivant des données (43) à un premier emplacement dans un premier bloc de la pluralité de blocs de la mémoire physique, et chaque opération de requête d'écriture subséquente pour le premier emplacement spécifié de la mémoire adressable logiquement est gérée en écrivant des données (43) à un premier emplacement dans un bloc différent de la pluralité de blocs de la mémoire physique jusqu'à ce que tous, à l'exception d'un des blocs, à savoir un dernier bloc de la pluralité de blocs de la mémoire physique, ont été écrits avec des données pour le premier emplacement spécifié de la mémoire adressable logiquement, et dans ce cas, les données de chacun des premiers emplacements dans la pluralité de blocs de la mémoire physique qui ont été précédemment écrites avec les données pour le premier emplacement spécifié de la mémoire adressable logiquement sont copiées (45) dans le dernier bloc de la pluralité de blocs de la mémoire physique, et les premiers emplacements de la pluralité de blocs de mémoire de la mémoire physique sont effacés (45).

2. Système de mémoire non volatile selon la revendication 1, ledit dispositif de commande étant en outre apte à configurer la mémoire physique de telle sorte que chaque requête pour une opération d'écriture pour un deuxième emplacement de la mémoire adressable logiquement est gérée par, pour chaque requête d'écriture de ce type, en écrivant des données une fois sur un bloc de mémoire de la pluralité de blocs de la mémoire physique non écrites précédemment pour le deuxième emplacement de la mémoire adressable logiquement.

3. Système de mémoire non volatile selon l'une quelconque des revendications 1 à 2, ledit dispositif de commande étant apte en outre à spécifier une endurance effective pour la pluralité de blocs de la mémoire physique, moyennant quoi l'endurance effective dépasse une endurance native associée à la mémoire physique, et où un nombre total de la pluralité de blocs de la mémoire physique attribué est proportionnel à un rapport de l'endurance effective à l'endurance native.

4. Système de mémoire non volatile selon l'une quelconque des revendications 1 à 3, ledit dispositif de commande étant en outre apte à mapper (44) un emplacement de la mémoire adressable logiquement à un ou plusieurs emplacements dans la pluralité de blocs de la mémoire physique après chaque opération d'écriture.

5. Système de mémoire non volatile selon l'une quelconque des revendications 1 à 4, comprenant en outre :
une interface (112) pour recevoir une valeur pour une endurance effective pour la pluralité de blocs de la mémoire physique.

6. Système de mémoire non volatile selon l'une quelconque des revendications 1 à 5, ledit dispositif de commande étant en outre apte à régler des valeurs d'endurance effective différentes pour différentes portions de la mémoire non volatile.

7. Système de mémoire non volatile selon l'une quelconque des revendications 1 à 6, dans lequel ledit dispositif de commande est en outre apte à réduire la quantité de la mémoire adressable logiquement pour atteindre une endurance effective spécifiée.

8. Système de mémoire non volatile selon l'une quelconque des revendications 1 à 7, dans lequel ledit dispositif de commande est en outre apte à augmenter la quantité de la mémoire adressable logiquement pour atteindre une endurance effective spécifiée.

9. Procédé de fonctionnement d'un dispositif de mémoire non volatile (106), comprenant :
(a) identifier (910) une quantité souhaitée de mémoire adressable logiquement ;
(b) configurer la mémoire physique en attribuant (906) une pluralité de blocs de la mémoire physique à des opérations de données pour la mémoire adressable logiquement, où chaque bloc de la pluralité de blocs de la mémoire physique possède une quantité de mémoire physique égale à la quantité souhaitée de la mémoire adressable logiquement, et où chaque requête pour une opération d'écriture pour un premier emplacement spécifié de la mémoire adressable logiquement est gérée par, pour chaque requête d'écriture de ce type, en écrivant des données une fois sur un bloc de mémoire de la pluralité de blocs de la mémoire physique sur lequel n'a pas été écrit pour le premier emplacement spécifié de la mémoire adressable logiquement ;
(c) lors d'une première opération d'écriture pour le premier emplacement spécifié de la mémoire adressable logiquement, écrire des données (43) à un premier emplacement dans un premier bloc de la pluralité de blocs de la mémoire physique ;
(d) lors de chaque opération d'écriture suivante pour le premier emplacement spécifié de la mémoire adressable logiquement, pour chaque opération d'écriture subséquente précitée, écrire des données (43) à un premier emplacement dans un bloc différent de la pluralité de blocs de la mémoire physique jusqu'à ce que tous les blocs, à l'exception d'un, à savoir un dernier bloc de la pluralité de blocs de la mémoire physique, a été écrit avec des données pour le premier emplacement spécifié de la mémoire adressable logiquement, et dans ce cas, copier des données (45) de chacun des premiers emplacements dans la pluralité de blocs de la mémoire physique qui a été écrit précédemment avec des données pour le premier emplacement spécifié de la mémoire adressable logiquement dans le dernier bloc de la pluralité de blocs de la mémoire physique ; et
(e) effacer (45) les premiers emplacements de la pluralité de blocs de mémoire de la mémoire physique, répéter ensuite les étapes (c) à (e) comme requis pour le premier emplacement spécifié de la mémoire adressable logiquement.

10. Procédé selon la revendication 9, comprenant en outre :
avant la configuration de la mémoire physique, spécifier (900) une endurance effective pour la pluralité de blocs de la mémoire physique, moyennant quoi l'endurance effective dépasse une endurance native associée à la mémoire physique, et où un nombre total de la pluralité de blocs de la mémoire physique attribué est proportionnel à un rapport de l'endurance effective à l'endurance native.

11. Procédé selon l'une quelconque des revendications 9 à 10, comprenant en outre :
après chaque opération d'écriture, mapper (44) le premier emplacement spécifié de la mémoire adressable logiquement à un ou plusieurs premiers emplacements dans la pluralité de blocs de la mémoire physique.

12. Procédé selon l'une quelconque des revendications 9 à 11, comprenant en outre :
(f) lors d'une première opération d'écriture pour un deuxième emplacement spécifié de la mémoire adressable logiquement, écrire des données (43) sur un deuxième emplacement dans le premier bloc de la mémoire physique ;
(g) lors de chaque opération d'écriture suivante pour le deuxième emplacement spécifié de la mémoire adressable logiquement, pour chaque opération d'écriture subséquente précitée, écrire des données (43) sur un deuxième emplacement dans un bloc différent de la pluralité de blocs de la mémoire physique jusqu'à ce que tous les blocs, à l'exception d'un, à savoir un dernier bloc de la pluralité de blocs de la mémoire physique, a été écrit avec des données pour le deuxième emplacement spécifié de la mémoire adressable logiquement, et dans ce cas, copier des données (45) de chaque deuxième emplacement dans la pluralité de blocs de la mémoire physique sur lesquels ont été écrites précédemment des données pour le deuxième emplacement spécifié de la mémoire adressable logiquement dans le dernier bloc de la pluralité de blocs de la mémoire physique ; et
(h) effacer (45) les deuxièmes emplacements de la pluralité de blocs de mémoire de la mémoire physique, ensuite la répétition des étapes (f) à (h) selon ce qui est requis pour le deuxième emplacement spécifique de la mémoire adressable logiquement.

13. Procédé selon l'une quelconque des revendications 9 à 12, ladite étape de spécification comprenant :
recevoir une instruction externe qui spécifie une endurance effective.

14. Support de stockage lisible par ordinateur ayant des instructions exécutables pour l'exécution du procédé indiqué dans l'une quelconque des revendications 9 à 13.
